# EUROPEAN PATENT APPLICATION

(11) **EP 4 601 426 A1**
(43) Date of publication of application: **13.08.2025**
(21) Application number: 23887486.1
(22) Date of filing: 29.06.2023
(51) Int. Cl.: H05K 7/20

(54) **ELECTRONIC ASSEMBLY AND ELECTRONIC DEVICE**

(30) Priority: 10.11.2022 CN 202211404048
(71) Applicant: Huawei Technologies Co., Ltd., Shenzhen, Guangdong 518129 (CN)
(72) Inventor: LI, Dingfang, Shenzhen, Guangdong 518129 (CN); LI, Min, Shenzhen, Guangdong 518129 (CN); YU, Fei, Shenzhen, Guangdong 518129 (CN); BAI, Lu, Shenzhen, Guangdong 518129 (CN)
(74) Representative: Huawei European IPR
(86) International application number: PCT/CN2023/103650
(87) International publication number: WO 2024/098790

(57) **Abstract**

This application relates to an electronic assembly and an electronic device, including a liquid cooling heat dissipation module and a plurality of floating modules. The plurality of floating modules are spaced apart on the liquid cooling heat dissipation module. The floating module includes a circuit board, a chip, and an elastic connecting member. The chip is disposed on one side of the circuit board, and the circuit board is connected to the liquid cooling heat dissipation module through the elastic connecting member. The elastic connecting member is configured to tightly press the circuit board against the liquid cooling heat dissipation module, so that the chip abuts against the liquid cooling heat dissipation module, and the plurality of floating modules are independent of each other and do not interfere with each other. The elastic connecting member is disposed to ensure heat dissipation reliability of each chip in the electronic assembly. In addition, because the liquid cooling heat dissipation module does not need to float, there is no need to dispose a large quantity of connection pipes, thereby reducing structural complexity of the liquid cooling heat dissipation module, reducing mounting space, and improving system integration of the electronic device.

## Description

This application claims priority to Chinese Patent Application No. 202211404048.X, filed with the China National Intellectual Property Administration on November 10, 2022 and entitled "ELECTRONIC ASSEMBLY AND ELECTRONIC DEVICE", which is incorporated herein by reference in its entirety.

### TECHNICAL FIELD

This application relates to the field of heat dissipation technologies, and in particular, to an electronic assembly and an electronic device.

### BACKGROUND

With rapid development of an internet technology (Internet Technology, IT) market, power consumption of various chips is continuously increasing, and conventional air cooling heat dissipation gradually evolves towards liquid cooling. In addition, due to carbon peaking and carbon neutrality requirements, a requirement is raised for an energy consumption ratio of an electronic device system, and full liquid cooling heat dissipation gradually becomes widely used.

A liquid cooling heat dissipation module usually includes a vapor chamber and a cooling plate. Because power consumption of a main chip is high, the main chip needs to be in close contact with the liquid cooling heat dissipation module during heat dissipation. In the conventional technology, a circuit board is fastened, so that the cooling plate for heat dissipation of the main chip is floating. In this way, the cooling plate is in close contact with the chip, while other low-power-consumption devices on the circuit board are in contact with the vapor chamber to dissipate heat. However, to ensure a floating function of the cooling plate and heat dissipation performance of the vapor chamber, a large quantity of connection pipes need to be laid, and large mounting space is occupied. Consequently, integration is reduced.

### SUMMARY

Embodiments of this application provide an electronic assembly and an electronic device, to resolve the foregoing problem of low integration in the conventional technology.

A first aspect of embodiments of this application provides an electronic assembly, including a liquid cooling heat dissipation module and a plurality of floating modules. The plurality of floating modules are spaced apart on the liquid cooling heat dissipation module. The floating module includes a circuit board, a chip, and an elastic connecting member. The chip is disposed on one side of the circuit board, and the circuit board is connected to the liquid cooling heat dissipation module through the elastic connecting member. The elastic connecting member is configured to tightly press the circuit board against the liquid cooling heat dissipation module, so that the chip abuts against the liquid cooling heat dissipation module.

In this solution, the circuit board in the floating module is connected to the liquid cooling heat dissipation module through the elastic connecting member. Under an action of the elastic connecting member, the circuit board can float towards the liquid cooling heat dissipation module, to ensure that the chip can be in close contact with the liquid cooling heat dissipation module. In addition, because the plurality of floating modules are independent of each other, and are spaced apart on the liquid cooling heat dissipation module, floating of two adjacent floating modules does not interfere with each other, and the elastic connecting member may apply elastic force based on a distance between the chip on the floating module to which the elastic connecting member belongs and the liquid cooling heat dissipation module, to ensure that a chip on each floating module can be in close contact with the liquid cooling heat dissipation module, and ensure heat dissipation reliability of each chip in the electronic assembly. In addition, because the liquid cooling heat dissipation module does not need to float, and is an integrated liquid cooling structure, there is no need to dispose a large quantity of connection pipes, thereby reducing structural complexity of the liquid cooling heat dissipation module, reducing mounting space, facilitating a compact design of the electronic assembly, and improving system integration of the electronic device.

In a possible design, the plurality of floating modules are mounted on two opposite sides of the liquid cooling heat dissipation module.

In this solution, the plurality of floating modules are mounted on the two opposite sides of the liquid cooling heat dissipation module, that is, the plurality of floating modules are mounted on both a first mounting surface and a second mounting surface of the liquid cooling heat dissipation module, so that more floating modules can be mounted, that is, heat can be dissipated for a plurality of chips with high power consumption simultaneously, thereby increasing a quantity of floating modules in the electronic assembly. In this way, the electronic device can have more chips with high power consumption, and performance of the electronic device is improved. In addition, due to a double-sided heat dissipation function of the liquid cooling heat dissipation module, a quantity of liquid cooling heat dissipation modules in the electronic device is reduced, and the system integration of the electronic device is further improved.

In a possible design, the elastic connecting member includes a connecting member and an elastic member, the connecting member passes through the elastic member, the circuit board is provided with a mounting hole, and the connecting member passes through the mounting hole and is connected to the liquid cooling heat dissipation module. One surface of the elastic member abuts against the connecting member, and the other surface abuts against the circuit board, to tightly press the chip on the circuit board against the liquid cooling heat dissipation module.

In this solution, the connecting member can pass through the mounting hole on the circuit board and be connected to the liquid cooling heat dissipation module, so that a shift of the floating module on the liquid cooling heat dissipation module can be limited, thereby avoiding interference between the plurality of floating modules, and improving structural stability of the electronic assembly. The elastic member is disposed between the connecting member and the circuit board, so that the elastic member can be compressed in a process of fastening the connecting member. In this way, the circuit board can drive, under an action of elastic force of the elastic member, the chip to float towards the liquid cooling heat dissipation module, thereby ensuring effective contact between the chip and the liquid cooling heat dissipation module, and improving the heat dissipation reliability of each chip in the electronic assembly.

In a possible design, the elastic member is a spring or a spring plate.

In this solution, an advantage of the spring or the spring plate is that the spring or the spring plate has a simple structure, and is easy to manufacture and low in costs. When the elastic member is the spring or the spring plate, an elastic function of the elastic connecting member can be ensured, so that the floating module can float relative to the liquid cooling heat dissipation module, thereby facilitating implementation of a floating function of the floating module, improving reliability of the elastic connecting member, reducing structural complexity of the elastic connecting member, and reducing costs.

In a possible design, the floating module further includes a first reinforcing framework and a second reinforcing framework, the first reinforcing framework is connected to one side of the circuit board and encloses the chip, and the second reinforcing framework is correspondingly disposed on the other side of the circuit board. The first reinforcing framework and the second reinforcing framework are provided with a through hole corresponding to a position of the mounting hole, and the connecting member sequentially passes through the elastic member, the second reinforcing framework, the circuit board, and the first reinforcing framework, and is connected to the liquid cooling heat dissipation module.

In this solution, the first reinforcing framework and the second reinforcing framework are disposed to improve strength of the circuit board around the chip. The elastic member is located between the second reinforcing framework and the connecting member, so that the elastic force generated by the elastic member first acts on the second reinforcing framework, and then transferred through the second reinforcing framework to the circuit board, so that force applied to the circuit board is more even, and deformation caused by excessively centralized stress on the circuit board at the elastic connecting member can be avoided, thereby avoiding a gap between the chip and the liquid cooling heat dissipation module, and preventing an impact on heat dissipation effect of the chip. In addition, the circuit board can be prevented from being deformed and damaged due to long-term pressure, thereby prolonging a service life of the circuit board.

In a possible design, the floating module further includes a first heat pipe, and the first heat pipe is disposed on two opposite sides of the circuit board. At least a part of the first heat pipe protrudes from an edge of the circuit board and is connected to the liquid cooling heat dissipation module.

In this solution, the first heat pipe is disposed on the two opposite sides of the circuit board, and can be connected to a low-power-consumption heat generating device other than the chip with high power consumption on the circuit board, so that heat dissipation can be performed on the low-power-consumption heat generating device on the circuit board. In addition, the first heat pipe is connected to the liquid cooling heat dissipation module, so that heat of the low-power-consumption heat generating device can be conducted to the liquid cooling heat dissipation module, to improve heat dissipation efficiency of the low-power-consumption heat generating device. In addition, because the low-power-consumption heat generating device on the circuit board is not in direct contact with the liquid cooling heat dissipation module for heat dissipation, a gap and a tolerance between the low-power-consumption heat generating device and the liquid cooling heat dissipation module do not need to be considered, thereby reducing heat dissipation difficulty of the low-power-consumption heat generating device on the circuit board, and ensuring heat dissipation reliability of the low-power-consumption heat generating device on the circuit board.

In a possible design, the first heat pipe includes a first section, a bending section, and a second section that are sequentially connected, the first section is connected to the circuit board, and the second section is connected to the liquid cooling heat dissipation module.

In this solution, the first section of the first heat pipe is connected to the circuit board, to absorb the heat of the low-power-consumption heat generating device on the circuit board. The second section is connected to the liquid cooling heat dissipation module, to transfer the absorbed heat to the liquid cooling heat dissipation module, thereby improving heat dissipation efficiency of the liquid cooling heat dissipation module. The bending section is disposed, so that second sections of the first heat pipe disposed on the two opposite sides of the circuit board are approximately at a same height, to reduce a height difference between the second sections of the first heat pipe on the two sides. In addition, an assembly tolerance in a height direction may be further generated after the first heat pipe is assembled, and a height difference is generated between second sections of a plurality of first heat pipes. In a floating process of the floating module, the bending section can be slightly deformed, to further absorb a tolerance after the first heat pipe is assembled, so that the second section can be in closer contact with the liquid cooling heat dissipation module, and heat conduction efficiency is improved.

In a possible design, the floating module further includes a fastening sheet, and the fastening sheet includes a body and a connecting sheet. The connecting sheet is connected to the liquid cooling heat dissipation module. At least a part of the second section is disposed between the body and the liquid cooling heat dissipation module.

In this solution, the fastening sheet is fastened to the liquid cooling heat dissipation module through the connecting sheet, so that the second section can be tightly pressed to the liquid cooling heat dissipation module through the body, to further reduce a height difference between a plurality of second sections after the plurality of first heat pipes are assembled, reduce a gap between the second section and the liquid cooling heat dissipation module, and improve a contact area between the second section and the liquid cooling heat dissipation module, thereby further improving the heat conduction efficiency. In addition, the floating module can be prevented from rotating or shifting relative to the liquid cooling heat dissipation module, thereby improving the structural stability of the electronic assembly.

In a possible design, the connecting sheet is provided with a fastening hole, and the connecting sheet is connected to the liquid cooling heat dissipation module in cooperation with the fastening hole.

In this solution, the connecting sheet is fastened to the liquid cooling heat dissipation module in cooperation with the fastening hole, so that the floating module can be easily disassembled, to facilitate replacement, addition, or reduction of the floating module, thereby improving user experience and reducing costs.

In a possible design, the fastening hole is a large circular hole or a groove hole.

In this solution, the fastening hole is the large circular hole or the groove hole, so that the fastening sheet can be moved and adjusted relative to the second section on the liquid cooling heat dissipation module, to reduce assembly tolerances that are in a width direction and a length direction of the circuit board and that may be generated after the first heat pipe is assembled. In this way, a coverage area of the body of the fastening sheet on the second section is improved, to improve an area in which the body tightly presses against the second section, ensure an effective contact area between the second section and the liquid cooling heat dissipation module, and avoid reducing the coverage area of the body on the second section due to the assembly tolerances. In this way, the contact area between the second section and the liquid cooling heat dissipation module is reduced, thereby reducing heat conduction efficiency of the first heat pipe. In addition, a tolerance of the fastening hole can further ensure that the first heat pipe is not stuck in an assembly process, thereby preventing force imbalance and improving the structural stability of the electronic assembly.

In a possible design, the body is provided with a recessed portion, and at least a part of the second section is disposed in the recessed portion.

In this solution, the recessed portion can limit a relative shift between the second section and the body, to prevent the body from rotating relative to the second section under external force, thereby preventing reduction of the area in which the body tightly presses the second section, and improving fastening effect of the fastening sheet.

In a possible design, the floating module further includes an elastic pressing sheet, and two ends of the elastic pressing sheet are connected to the liquid cooling heat dissipation module. At least a part of the second section is disposed between the elastic pressing sheet and the liquid cooling heat dissipation module.

In this solution, the elastic pressing sheet is elastic. When the two ends of the elastic pressing sheet are fastened to the liquid cooling heat dissipation module, the second section can be tightly pressed against the liquid heat dissipation module through an elastic deformation part in the center, to reduce the tolerance after the first heat pipe is assembled, increase the effective contact area between the second section and the liquid heat dissipation module, and ensure heat conduction efficiency of the second section. In addition, the elastic pressing sheet may simultaneously fasten a plurality of second sections, to improve assembly efficiency. Further, the elastic pressing sheet has a simple structure, and is easy to manufacture and easy to produce in batches, to further reduce manufacturing costs of the electronic assembly.

In a possible design, the liquid cooling heat dissipation module includes a first vapor chamber and a plurality of cooling plates, the plurality of cooling plates are spaced apart on the first vapor chamber, and the plurality of cooling plates protrude from the first vapor chamber. Positions of the plurality of cooling plates correspond to positions of the plurality of floating modules. The chip abuts against the cooling plate, and the second section is connected to the first vapor chamber.

In this solution, the cooling plate protrudes from a surface of the first vapor chamber, so that when the chip abuts against the cooling plate, another part on the circuit board can be in no contact with the first vapor chamber, thereby facilitating arrangement of the first heat pipe and facilitating heat dissipation of the low-power-consumption heat generating device on the circuit board through the first heat pipe.

In a possible design, the floating module further includes a second vapor chamber, and the second vapor chamber is fastened on two opposite sides of the circuit board. At least a part of the first section is disposed between the second vapor chamber and the circuit board.

In this solution, the second vapor chamber is disposed to cover the low-power-consumption heat generating device on the circuit board, so that temperature equalization can be performed on the low-power-consumption heat generating device on the circuit board, and good temperature equalization performance is provided, thereby preventing the low-power-consumption heat generating device from being overheated. In addition, a part of the first section of the first heat pipe is disposed between the second vapor chamber and the circuit board, so that the second vapor chamber can transfer the heat of the low-power-consumption heat generating device to the first section, and then transfer the heat to the liquid cooling heat dissipation module. Therefore, the second vapor chamber can reduce a quantity of used first heat pipes, costs are reduced, the heat conduction efficiency of the low-power-consumption heat generating device on the circuit board is improved, impact of the fastened first heat pipe on the circuit board is reduced, and a yield rate of the floating module is improved.

In a possible design, there is a gap between the second vapor chamber and the first vapor chamber.

In this solution, there is the gap between the second vapor chamber and the first vapor chamber, so that the floating module can have space of floating relative to the liquid cooling heat dissipation module, to ensure that the chip can be in close contact with the cooling plate, and ensure the heat dissipation reliability of the chip.

In a possible design, the floating module further includes a second heat pipe, a groove is disposed on a side that is of the second vapor chamber and that is away from the circuit board, and the second heat pipe is disposed in the groove.

In this solution, heat absorbed by the second vapor chamber in the structure can be transferred to the second heat pipe, to further improve temperature equalization effect of the second vapor chamber, thereby effectively preventing the excessively high heat of the low-power-consumption heat generating device on the circuit board, prolonging a service life of the circuit board, and improving use reliability of the electronic assembly.

In a possible design, a cross section of the first heat pipe is in a rectangle shape or an oblate shape, and a cross section of the second heat pipe is in a rectangle shape or an oblate shape.

In this solution, when the cross sections of the first heat pipe and the second heat pipe are in the rectangle shape or the oblate shape, the first heat pipe and the second heat pipe can have flat surfaces, to facilitate assembly and tight pressing of the first heat pipe and the second heat pipe, improve fastening effect of the first heat pipe and the second heat pipe, and further reduce thicknesses of the first heat pipe and the second heat pipe, thereby reducing an overall thickness of the electronic assembly and improving the system integration of the electronic device.

A second aspect of embodiments of this application provides an electronic device. The electronic device includes a housing and the electronic assembly according to any one of the foregoing embodiments, and the electronic assembly is mounted in the housing. Because the electronic assembly has the foregoing technical effect, the electronic device including the electronic assembly should have corresponding technical effect. Details are not described herein again.

It should be understood that the foregoing general descriptions and the following detailed descriptions are merely examples, and are not intended to limit this application.

### BRIEF DESCRIPTION OF DRAWINGS

FIG. 1 is a diagram of a structure of a liquid cooling heat dissipation module of an electronic assembly in the conventional technology;
FIG. 2 is a diagram of a structure of an electronic assembly according to an embodiment of this application;
FIG. 3 is a diagram of a structure of a liquid cooling heat dissipation module in FIG. 2;
FIG. 4 is a diagram of a structure of a floating module in FIG. 2;
FIG. 5 is a diagram of a structure of the floating module in FIG. 4 from another perspective;
FIG. 6 is a partially enlarged view of a position A in FIG. 2;
FIG. 7 is a partially enlarged view of a position B in FIG. 4;
FIG. 8 is a partial diagram of the electronic assembly in FIG. 2 according to another embodiment;
FIG. 9 is a sectional view of a first heat pipe in FIG. 2 according to an embodiment; and
FIG. 10 is a sectional view of the first heat pipe in FIG. 2 according to another embodiment.

Reference numerals:
1': vapor chamber;
2': floating cooling plate;
3': connection pipe;
1: liquid cooling heat dissipation module;
   11: first vapor chamber;
      111: first mounting surface;
      112: second mounting surface;
   12: cooling plate;
2: floating module;
   21: circuit board;
   22: chip;
   23: first heat pipe;
      231: first section;
      232: bending section;
      233: second section;
   24: elastic connecting member;
      241: connecting member;
      242: elastic member;
   25: fastening sheet;
      251: body;
         251a: recessed portion;
      252: connecting sheet;
         252a: fastening hole;
   26: elastic pressing sheet;
   27: second vapor chamber;
      271: groove;
   28: second heat pipe;
   29a: first reinforcing framework; and
   29b: second reinforcing framework.

The accompanying drawings herein are incorporated into this specification and constitute a part of this specification, to show embodiments in accordance with this application, and are used, together with this specification, to explain the principle of this application.

### DESCRIPTION OF EMBODIMENTS

To better understand technical solutions of this application, the following describes embodiments of this application in detail with reference to the accompanying drawings.

In a specific embodiment, the following further describes this application in detail with reference to specific embodiments and the accompanying drawings.

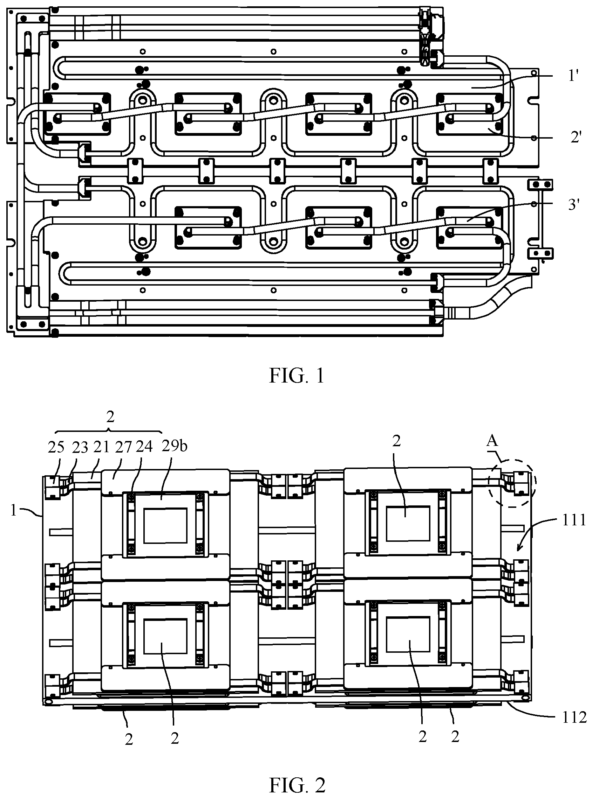

For an electronic device, an electronic assembly is usually disposed. A main chip is an important part of the electronic assembly, and is disposed on a circuit board. Because power consumption of the main chip is high, the main chip needs to be in close contact with the liquid cooling heat dissipation module during heat dissipation. In the conventional technology, the liquid cooling heat dissipation module includes a cooling plate and a vapor chamber. A circuit board is fastened, so that the cooling plate for heat dissipation of the main chip is floating. In this way, the cooling plate is in close contact with the chip, while other low-power-consumption devices on the circuit board are in contact with the vapor chamber to dissipate heat. FIG. 1 is a diagram of a structure of a liquid cooling heat dissipation structure of an electronic assembly in the conventional technology. An elastic connecting member needs to be mounted on a floating cooling plate 2', and a large quantity of connection pipes 3' need to be laid in a staggered manner, so that the floating cooling plate 2' in the structure can float, and liquid for cooling in the floating cooling plate 2' and a vapor chamber 1' can flow. As a result, the connection pipes 3' occupy large mounting space, and system integration is reduced.

To resolve the technical problem, embodiments of this application provide an electronic assembly and an electronic device. The electronic device includes an electronic device like a computer, a server, a storage, or a switch. This is not limited herein. The following further describes this application in detail with reference to specific embodiments and the accompanying drawings.

An embodiment of this application provides an electronic assembly. As shown in FIG. 2 to FIG. 5, the electronic assembly includes a liquid cooling heat dissipation module 1 and a plurality of floating modules 2. The plurality of floating modules 2 are spaced apart on the liquid cooling heat dissipation module 1. The floating module 2 includes a circuit board 21, a chip 22, and an elastic connecting member 24. The chip 22 is disposed on one side of the circuit board 21. The circuit board 21 is connected to the liquid cooling heat dissipation module 1 through the elastic connecting member 24. The elastic connecting member 24 is configured to tightly press the circuit board 21 against the liquid cooling heat dissipation module 1, so that the chip 22 abuts against the liquid cooling heat dissipation module 1.

In this embodiment, as shown in FIG. 2 to FIG. 5, the circuit board 21 in the floating module 2 is connected to the liquid cooling heat dissipation module 1 through the elastic connecting member 24. Under an action of the elastic connecting member 24, the circuit board 21 can float towards the liquid cooling heat dissipation module 1, to ensure that the chip 22 can be in close contact with the liquid cooling heat dissipation module 1. In addition, because the plurality of floating modules 2 are independent of each other, and are spaced apart on the liquid cooling heat dissipation module 1, floating of two adjacent floating modules 2 does not interfere with each other, and the elastic connecting member 24 may apply elastic force based on a distance between the chip 22 on the floating module 2 to which the elastic connecting member 24 belongs and the liquid cooling heat dissipation module 1, to ensure that a chip 22 on each floating module 2 can be in close contact with the liquid cooling heat dissipation module 1, and ensure heat dissipation reliability of each chip 22 in the electronic assembly. In addition, because the liquid cooling heat dissipation module 1 does not need to float, and is an integrated liquid cooling structure, there is no need to dispose a large quantity of connection pipes, thereby reducing structural complexity of the liquid cooling heat dissipation module 1, reducing mounting space, facilitating a compact design of the electronic assembly, and improving system integration of the electronic device.

The plurality of floating modules 2 do not interfere with each other, thereby facilitating addition, reduction, or replacement, by a user, of the floating module 2 having the chip 22 or the circuit board 21 as required, to meet a performance requirement of the user for the electronic device, with no need to replace all the floating modules 2 or the circuit board 21 at one time, thereby reducing costs and improving user experience.

In addition, the circuit board 21 in this embodiment may be a printed circuit board (Printed Circuit Board, PCB), or may be another circuit board. This is not limited herein.

It should be noted that this embodiment of this application is mainly applied to a full liquid cooling heat dissipation scenario, but is not limited to the full liquid cooling heat dissipation scenario. This embodiment of this application may also be applied to another heat dissipation scenario, for example, a shell heat dissipation scenario. This is not limited herein.

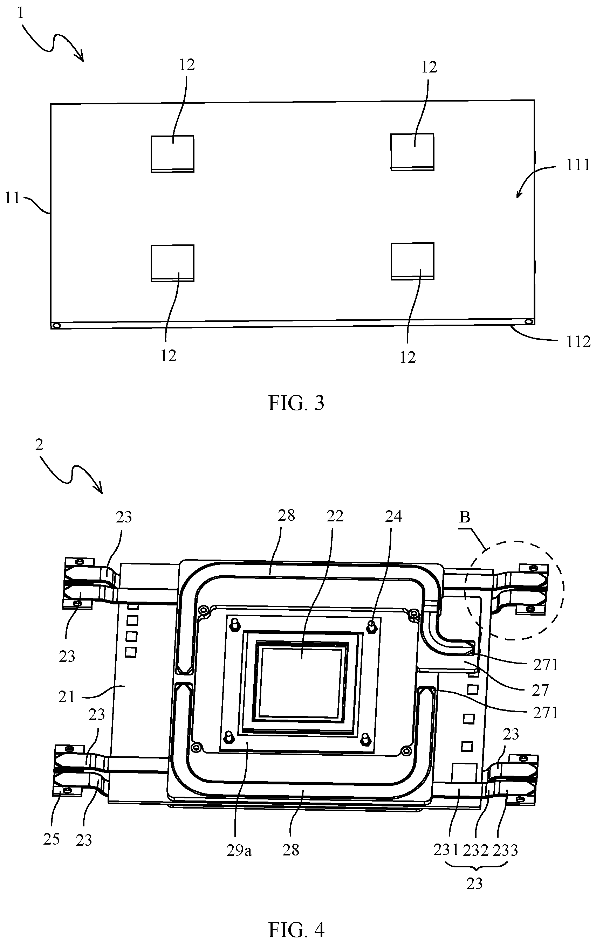

In addition, as shown in FIG. 2 and FIG. 3, because the liquid cooling heat dissipation module 1 in the electronic assembly does not need to float, and is the integrated liquid cooling structure, there is no need to dispose a large quantity of connection pipes. Therefore, there is mounting space on two opposite sides of the liquid cooling heat dissipation module 1 in this embodiment of this application, so that the liquid cooling heat dissipation module 1 may have both a first mounting surface 111 and a second mounting surface 112 that are opposite to each other, that is, the floating module 2 may be mounted on the first mounting surface 111 or the second mounting surface 112 to implement a single-sided heat dissipation function of the liquid cooling heat dissipation module 1, and the floating modules 2 may alternatively be mounted on both the first mounting surface 111 and the second mounting surface 112 to implement a double-sided heat dissipation function of the liquid cooling heat dissipation module 1. This is not limited herein.

In a specific embodiment, as shown in FIG. 2 and FIG. 3, the plurality of floating modules 2 are mounted on the two opposite sides of the liquid cooling heat dissipation module 1.

In this embodiment, as shown in FIG. 2 and FIG. 3, the plurality of floating modules 2 are mounted on the two opposite sides of the liquid cooling heat dissipation module 1, that is, the plurality of floating modules 2 are mounted on both the first mounting surface 111 and the second mounting surface 112 of the liquid cooling heat dissipation module 1, so that more floating modules 2 can be mounted, that is, heat can be dissipated for a plurality of chips 22 with high power consumption simultaneously, thereby increasing a quantity of floating modules 2 in the electronic assembly. In this way, the electronic device can have more chips 22 with high power consumption, and performance of the electronic device is improved. In addition, due to the double-sided heat dissipation function of the liquid cooling heat dissipation module 1, a quantity of liquid cooling heat dissipation modules 1 in the electronic device is reduced, and system integration of the electronic device is further improved.

In another embodiment, a plurality of floating modules 2 may be disposed on only one side of the liquid cooling heat dissipation module 1 based on an actual structure and a requirement of the electronic device, to reduce costs of the electronic device. Certainly, a floating module 2 may be further added based on a subsequent use requirement, to improve performance of the electronic device and meet a use requirement of the user. This is not limited herein.

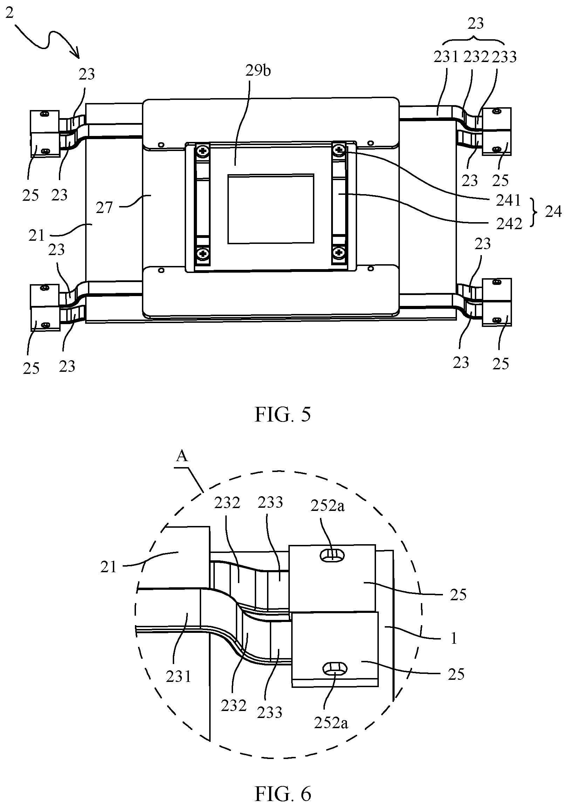

In a specific embodiment, as shown in FIG. 4 and FIG. 5, the elastic connecting member 24 includes a connecting member 241 and an elastic member 242, the connecting member 241 passes through the elastic member 242, the circuit board 21 is provided with a mounting hole, and the connecting member 241 passes through the mounting hole and is connected to the liquid cooling heat dissipation module 1. One surface of the elastic member 242 abuts against the connecting member 241, and the other surface abuts against the circuit board 21, to tightly press the chip 22 on the circuit board 21 against the liquid cooling heat dissipation module 1.

In this embodiment, as shown in FIG. 4 and FIG. 5, the connecting member 241 can pass through the mounting hole on the circuit board 21 and be connected to the liquid cooling heat dissipation module 1, so that a shift of the floating module 2 on the liquid cooling heat dissipation module 1 can be limited, thereby avoiding interference between the plurality of floating modules 2, and improving structural stability of the electronic assembly. The elastic member 242 is disposed between the connecting member 241 and the circuit board 21, so that the elastic member 242 can be compressed in a process of fastening the connecting member 241. In this way, the circuit board 21 can drive, under an action of elastic force of the elastic member 242, the chip 22 to float towards the liquid cooling heat dissipation module 1, thereby ensuring effective contact between the chip 22 and the liquid cooling heat dissipation module 1, and improving the heat dissipation reliability of each chip 22 in the electronic assembly.

The elastic connecting member 24 in this embodiment is not limited to a combination mode of the connecting member 241 and the elastic member 242, and may also be in another floating connection manner that can play a fastening and elastic role. This is not limited herein.

In a specific embodiment, as shown in FIG. 5, the elastic member 242 is a spring or a spring plate.

In this embodiment, the spring or the spring plate has the advantages of simple structure, being easy to manufacture, and low costs. When the elastic member 242 is the spring or the spring plate, an elastic function of the elastic connecting member 24 can be ensured, so that the floating module 2 can float relative to the liquid cooling heat dissipation module 1, thereby facilitating implementation of a floating function of the floating module 2, improving reliability of the elastic connecting member 24, reducing structural complexity of the elastic connecting member 24, and reducing costs.

Certainly, the elastic member 242 may alternatively be another elastic structure. This is not limited herein.

In the specific embodiment shown in FIG. 5, the elastic member 242 of the elastic connecting member 24 is a spring plate. In this structure, two ends of the spring plate are provided with through holes, so that the connecting member 241 can pass through the through hole. A center of the spring plate is provided with an elastic deformation part. When the two ends of the spring plate are tightly pressed, the elastic deformation part in the center can deform to generate elastic force. During mounting, the connecting member 241 first passes through the through holes at the two ends of the spring plate, and then the connecting member 241 passes through mounting holes on the circuit board 21 and is connected to the liquid cooling heat dissipation module 1. As the connecting member 241 is fastened, the two ends of the spring plate are tightly pressed, and the elastic deformation part in the center is compressed to deform, so that the circuit board 21 can be tightly pressed towards the liquid cooling heat dissipation module 1 to form floating, and the chip 22 is driven to be in close contact with the liquid cooling heat dissipation module 1. In other words, the elastic connecting member 24 in the structure includes one spring plate and two connecting members 241. The elastic deformation part of the spring plate can increase a contact area between the spring plate and the circuit board 21, so that force applied to the circuit board 21 is more even, and deformation caused by excessively centralized stress on the circuit board at the elastic connecting member 24 can be avoided, thereby avoiding a gap between the chip 22 and the liquid cooling heat dissipation module 1, and preventing an impact on heat dissipation effect of the chip 22. In addition, a quantity of elastic members 242 can be reduced, and assembly efficiency can be improved.

A plurality of elastic connecting members 24 may be disposed, for example, two or four elastic connecting members 24, so that force applied to the circuit board 21 is more even, and a function of tightly pressing the circuit board 21 and the chip 22 is improved. This is not limited herein. In the specific embodiment shown in FIG. 3 and FIG. 4, two elastic connecting members 24 are disposed, and the two elastic connecting members 24 are disposed opposite to each other, to further improve the function of tightly pressing the circuit board 21.

In addition, the mounting holes on the circuit board 21 may be disposed around the chip 22. In the specific embodiment shown in FIG. 4 and FIG. 5, the mounting holes on the circuit board 21 are disposed at four corners close to the chip 22. The elastic connecting member 24 passes through from this position to increase pressure on a center of the elastic connecting member 24, so that force on a mounting position of the chip 22 of the circuit board 21 is more even, and the chip 22 is more easily tightly pressed against the liquid cooling heat dissipation module 1, thereby further ensuring effective contact between the chip 22 and the liquid cooling heat dissipation module 1, reducing a requirement for an elastic coefficient of the elastic member 242, and reducing manufacturing costs.

In a specific embodiment, as shown in FIG. 4 and FIG. 5, the floating module 2 further includes a first reinforcing framework 29a and a second reinforcing framework 29b, the first reinforcing framework 29a is connected to one side of the circuit board 21 and encloses the chip 22, and the second reinforcing framework 29b is correspondingly disposed on the other side of the circuit board 21. The first reinforcing framework 29a and the second reinforcing framework 29b are provided with a through hole corresponding to a position of the mounting hole, and the connecting member 241 sequentially passes through the elastic member 242, the second reinforcing framework 29b, the circuit board 21, and the first reinforcing framework 29a, and is connected to the liquid cooling heat dissipation module 1.

In this embodiment, as shown in FIG. 4 and FIG. 5, the first reinforcing framework 29a and the second reinforcing framework 29b are disposed to improve strength of the circuit board 21 around the chip 22. The elastic member 242 is located between the second reinforcing framework 29b and the connecting member 241, so that the elastic force generated by the elastic member 242 first acts on the second reinforcing framework 29b, and then transferred through the second reinforcing framework 29b to the circuit board 21, so that force applied to the circuit board 21 is more even, and deformation caused by excessively centralized stress on the circuit board at the elastic connecting member 24 can be avoided, thereby avoiding a gap between the chip 22 and the liquid cooling heat dissipation module 1, and preventing an impact on heat dissipation effect of the chip 22. In addition, the circuit board 21 can be prevented from being deformed and damaged due to long-term pressure, thereby prolonging a service life of the circuit board 21.

Sizes and shapes of the first reinforcing framework 29a and the second reinforcing framework 29b may be configured based on an actual size and shape of the chip 22. This is not limited herein.

In a specific embodiment, as shown in FIG. 2 to FIG. 5, the floating module 2 further includes a first heat pipe 23, and the first heat pipe 23 is disposed on two opposite sides of the circuit board 21. At least a part of the first heat pipe 23 protrudes from an edge of the circuit board 21 and is connected to the liquid cooling heat dissipation module 1.

In this embodiment, as shown in FIG. 2 to FIG. 5, the first heat pipe 23 is disposed on the two opposite sides of the circuit board 21, and can be connected to a low-power-consumption heat generating device other than the chip 22 with high power consumption on the circuit board 21, so that heat dissipation can be performed on the low-power-consumption heat generating device on the circuit board 21. In addition, the first heat pipe 23 is connected to the liquid cooling heat dissipation module 1, so that heat of the low-power-consumption heat generating device can be conducted to the liquid cooling heat dissipation module, to improve heat dissipation efficiency of the low-power-consumption heat generating device. In addition, there is a tolerance in a height of the low-power-consumption heat generating device on the circuit board 21, and there may be a gap not exactly the same between the low-power-consumption heat generating device and the liquid cooling heat dissipation module 1. Because the low-power-consumption heat generating device on the circuit board 21 is not in direct contact with the liquid cooling heat dissipation module 1 for heat dissipation, the gap and the tolerance between the low-power-consumption heat generating device and the liquid cooling heat dissipation module 1 may not be considered, thereby reducing heat dissipation difficulty of the low-power-consumption heat generating device on the circuit board 21, and ensuring heat dissipation reliability of the low-power-consumption heat generating device on the circuit board 21.

In addition, under the action of the elastic connecting member 24, the circuit board 21 can float relative to the liquid cooling heat dissipation module 1. In a process in which the circuit board 21 floats towards the liquid cooling heat dissipation module 1, the first heat pipe 23 disposed on a side of the circuit board 21 facing the liquid cooling heat dissipation module 1 can be tightly pressed between the circuit board 21 and the liquid cooling heat dissipation module 1. In this way, the tolerance of the low-power-consumption heat generating device on the circuit board 21 can be absorbed, so that the low-power-consumption heat generating device on the circuit board 21 is in closer contact with the first heat pipe 23, thereby improving heat dissipation reliability.

The heat pipe quickly conducts heat in a phase change process in which a medium is evaporated at a hot end and then condensed at a cold end. The heat pipe generally includes an envelope, a wick and end caps. An interior of the heat pipe is exhausted to a negative-pressure state and filled with an appropriate liquid. Such a liquid has a low boiling point and is volatile. A pipe wall is provided with a wick that is made of a capillary porous material. One end of the heat pipe is an evaporation end, and the other end is a condensation end. When one end of the heat pipe is heated, the liquid in the capillary pipe is rapidly vaporized, and a vapor flows to the other end under power of thermal diffusion, and condenses at the cold end to release heat. The liquid then flows back to the evaporation end along the porous material under a capillary action. This process repeats until temperatures at both the ends of the heat pipe are the same. Because the circulation occurs rapidly, heat can be incessantly conducted to the outside. Both the first heat pipe 23 and the second heat pipe 28 in this application are based on this working principle.

In a specific embodiment, as shown in FIG. 4 to FIG. 6, the first heat pipe 23 includes a first section 231, a bending section 232, and a second section 233 that are sequentially connected, the first section 231 is connected to the circuit board 21, and the second section 233 is connected to the liquid cooling heat dissipation module 1.

In this embodiment, as shown in FIG. 4 to FIG. 6, the first section 231 of the first heat pipe 23 is connected to the circuit board 21, to absorb the heat of the low-power-consumption heat generating device on the circuit board 21. The second section 233 is connected to the liquid cooling heat dissipation module 1, to transfer the absorbed heat to the liquid cooling heat dissipation module 1, thereby improving heat dissipation efficiency of the liquid cooling heat dissipation module 1. The bending section 232 is disposed, so that second sections 233 of the first heat pipe 23 disposed on the two opposite sides of the circuit board 21 are approximately at a same height, to reduce a height difference between the second sections 233 of the first heat pipe 23 on the two sides. In addition, an assembly tolerance in a height direction may be further generated after the first heat pipe 23 is assembled, and a height difference is generated between second sections 233 of a plurality of first heat pipes 23. In a floating process of the floating module 2, the bending section 232 can be slightly deformed, to further absorb a tolerance after the first heat pipe 23 is assembled, so that the second section 233 can be in closer contact with the liquid cooling heat dissipation module 1, and heat conduction efficiency is improved.

A bending shape and a size of the bending section 232 may be configured based on an actual structure of the electronic assembly, and bending shapes and sizes of bending sections 232 of the first heat pipe 23 on the two opposite sides of the circuit board 21 may be different, it can be ensured that the second sections 233 of the first heat pipe 23 disposed on the two opposite sides of the circuit board 21 are approximately at a same height.

In addition, the first end 231 may be fastened to the circuit board 21 through welding. Certainly, the first end 231 may alternatively be fastened to the circuit board in another manner. This is not limited herein.

In addition, a plurality of first heat pipes 23 may be disposed, and may be configured based on sizes, ranges, and a quantity of low-power-consumption heat generating devices on the circuit board 21. For example, a quantity of first heat pipes 23 may be two, four, six, eight, or the like. In addition, quantities of first heat pipes 23 on two sides of the circuit board 21 may be the same or may be different, provided that heat dissipation effect of the low-power-consumption heat generating device on the circuit board 21 can be ensured. This is not limited herein. In the specific embodiment shown in FIG. 2 to FIG. 5, there are eight first heat pipes 23, which are evenly disposed on two sides of the circuit board 21, that is, four first heat pipes are disposed on each side, to improve the heat dissipation efficiency of the low-power-consumption heat generating device on the circuit board 21.

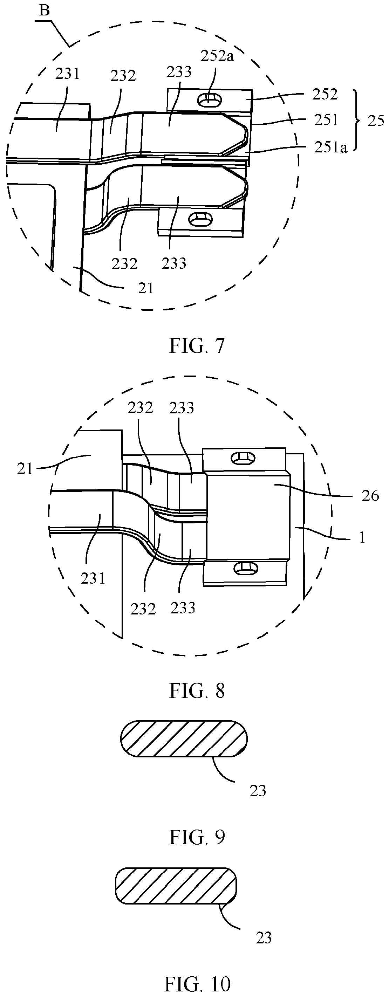

In a specific embodiment, as shown in FIG. 6 and FIG. 7, the floating module 2 further includes a fastening sheet 25. The fastening sheet 25 includes a body 251 and a connecting sheet 252, and the connecting sheet 252 is connected to the liquid cooling heat dissipation module 1. At least a part of the second section 233 is disposed between the body 251 and the liquid cooling heat dissipation module 1.

In this embodiment, as shown in FIG. 6 and FIG. 7, the fastening sheet 25 is fastened to the liquid cooling heat dissipation module 1 through the connecting sheet 252, so that the second section 233 can be tightly pressed to the liquid cooling heat dissipation module 1 through the body 251, to further reduce a height difference between a plurality of second sections 233 after the plurality of first heat pipes 23 are assembled, reduce a gap between the second section 233 and the liquid cooling heat dissipation module 1, and improve a contact area between the second section 233 and the liquid cooling heat dissipation module 1, thereby further improving heat conduction efficiency. In addition, the floating module 2 can be prevented from rotating or shifting relative to the liquid cooling heat dissipation module 1, thereby improving the structural stability of the electronic assembly.

The connecting sheet 252 may be connected to the liquid cooling heat dissipation module 1 through welding, riveting, clamping, connection with a fastener, or the like. This is not limited herein.

In addition, a plurality of fastening sheets 25 may be disposed, and a quantity of fastening sheets 25 matches the quantity of the first heat pipes 23. This is not limited herein.

In a specific embodiment, as shown in FIG. 6 and FIG. 7, the connecting sheet 252 is provided with a fastening hole 252a, the connecting sheet 252 is connected to the liquid cooling heat dissipation module 1 in cooperation with the fastening hole 252a, and the fastening hole 252a is a large circular hole or a groove hole.

In this embodiment, as shown in FIG. 6 and FIG. 7, the connecting sheet 252 is fastened to the liquid cooling heat dissipation module 1 in cooperation with the fastening hole 252a, so that the floating module 2 can be easily disassembled, to facilitate replacement, addition, or reduction of the floating module 2, thereby improving user experience and reducing costs.

The fastening hole 252a may be used in cooperation with a fastener such as a screw. This is not limited herein.

In a specific embodiment, as shown in FIG. 6 and FIG. 7, the fastening hole 252a is a large circular hole or a groove hole.

After the first heat pipe 23 is assembled, assembly tolerances that are in a width direction and a length direction of the circuit board 21 may be generated, that is, after the first heat pipe 23 is assembled, lengths of the first heat pipes 23 extending from edges of the circuit board 21 may be different, so that the second sections 233 are unevenly arranged along the edges of the circuit board 21 in the width direction and the length direction. In this embodiment, as shown in FIG. 6 and FIG. 7, the fastening hole 252a is the large circular hole or the groove hole, so that the fastening sheet 25 can be moved and adjusted relative to the second section 233 on the liquid cooling heat dissipation module 1, to reduce assembly tolerances that are in a width direction and a length direction of the circuit board 21 and that may be generated after the first heat pipe 23 is assembled. In this way, a coverage area of the body 251 of the fastening sheet 25 on the second section 233 is improved, to improve an area in which the body 251 tightly presses against the second section 233, ensure an effective contact area between the second section 233 and the liquid cooling heat dissipation module 1, and avoid reducing the coverage area of the body 251 on the second section 233 due to the assembly tolerances. In this way, the contact area between the second section 233 and the liquid cooling heat dissipation module 1 is reduced, thereby reducing heat conduction efficiency of the first heat pipe 23. In addition, a tolerance of the fastening hole 252a can further ensure that the first heat pipe 23 is not stuck in an assembly process, thereby preventing force imbalance and improving the structural stability of the electronic assembly.

Certainly, the fastening hole 252a may alternatively be a strip-shaped hole or the like. This is not limited herein.

In a specific embodiment, as shown in FIG. 6 and FIG. 7, the body 251 is provided with a recessed portion 251a, and at least a part of the second section 233 is disposed in the recessed portion 251a.

In this embodiment, as shown in FIG. 6 and FIG. 7, the recessed portion 251a can limit a relative shift between the second section 233 and the body 251, to prevent the body 251 from rotating relative to the second section 233 under external force, thereby preventing reduction of the area in which the body 251 tightly presses the second section 233, and improving fastening effect of the fastening sheet 25.

In addition, in the specific embodiment shown in FIG. 6 and FIG. 7, when the body 251 has the recessed portion 251a, the fastening sheet 25 can tightly press and fasten the second section 233 with only one connecting sheet 252, thereby reducing a volume of the fastening sheet 25. When the plurality of second sections 233 are arranged densely, the second sections 233 may also be tightly pressed and fastened through the fastening sheet 25.

Certainly, in another embodiment, a connecting sheet 252 may be disposed on each of two sides of the body 251, to further improve fastening effect of the second section 233.

In another embodiment, a plurality of recessed portions 251a may be disposed on the body 251, so that the body 251 can tightly press the plurality of second sections 233 simultaneously, so that the plurality of densely arranged second sections 233 can be fastened simultaneously, less fastening sheets 25 can be used, and assembly efficiency can be improved. This is not limited herein.

In another specific embodiment, as shown in FIG. 8, the floating module 2 further includes an elastic pressing sheet 26, and two ends of the elastic pressing sheet 26 are connected to the liquid cooling heat dissipation module 1, and at least a part of the second section 233 is disposed between the elastic pressing sheet 26 and the liquid cooling heat dissipation module 1.

In this embodiment, as shown in FIG. 8, the elastic pressing sheet 26 is elastic. When the two ends of the elastic pressing sheet 26 are fastened to the liquid cooling heat dissipation module 1, the second section 233 can be tightly pressed against the liquid heat dissipation module 1 through an elastic deformation part in the center, to reduce the tolerance after the first heat pipe 23 is assembled, increase the effective contact area between the second section 233 and the liquid heat dissipation module 1, and ensure heat conduction efficiency of the second section 233. In addition, the elastic pressing sheet 26 may simultaneously fasten a plurality of second sections 233, to improve assembly efficiency. Further, the elastic pressing sheet 26 has a simple structure, and is easy to manufacture and easy to produce in batches, to further reduce manufacturing costs of the electronic assembly.

A length and a size of the elastic pressing sheet 26 may be configured based on actual distribution and a size of the first heat pipe 23, so that the elastic pressing sheet 26 can fasten at least one second section 233. This is not limited herein.

In addition, holes such as large circular holes, groove holes, and strip-shaped holes may also be disposed at the two ends of the elastic pressing sheet 26, so that a position of the elastic pressing sheet 26 can be adjusted relative to the second section 233, to further absorb the tolerance after the first heat pipe 23 is assembled. This is not limited herein.

Certainly, the second section 233 may alternatively be fastened or tightly pressed against the liquid heat dissipation module 1 in another structure or manner. This is not limited herein.

In a specific embodiment, as shown in FIG. 2 to FIG. 5, the liquid cooling heat dissipation module 1 includes a first vapor chamber 11 and a plurality of cooling plates 12, the plurality of cooling plates 12 are spaced apart on the first vapor chamber 11, and the plurality of cooling plates 12 protrude from the first vapor chamber 11. Positions of the plurality of cooling plates 12 correspond to positions of the plurality of floating modules 2. The chip 22 abuts against the cooling plate 12, and the second section 233 is connected to the first vapor chamber 11.

In this embodiment, as shown in FIG. 2 to FIG. 5, the cooling plate 12 protrudes from a surface of the first vapor chamber 11, so that when the chip 22 abuts against the cooling plate 12, another part on the circuit board 21 can be in no contact with the first vapor chamber 11, thereby facilitating arrangement of the first heat pipe 23 and facilitating heat dissipation of the low-power-consumption heat generating device on the circuit board 21 through the first heat pipe 23.

The cooling plate 12 may be fastened to the first vapor chamber 11 through welding, to implement an integrated liquid cooling heat dissipation module 1. Certainly, the cooling plate 12 may alternatively be fastened to the first vapor chamber 11 in another manner. This is not limited herein.

In a specific embodiment, as shown in FIG. 4 and FIG. 5, the floating module 2 further includes a second vapor chamber 27, and the second vapor chamber 27 is fastened on two opposite sides of the circuit board 21. At least a part of the first section 231 is disposed between the second vapor chamber 27 and the circuit board 21.

In this embodiment, as shown in FIG. 4 and FIG. 5, the second vapor chamber 27 is disposed to cover the low-power-consumption heat generating device on the circuit board 21, so that temperature equalization can be performed on the low-power-consumption heat generating device on the circuit board 21, and good temperature equalization performance is provided, thereby preventing the low-power-consumption heat generating device from being overheated. In addition, a part of the first section 231 of the first heat pipe 23 is disposed between the second vapor chamber 27 and the circuit board, so that the second vapor chamber 27 can transfer the heat of the low-power-consumption heat generating device to the first section 231, and then transfer the heat to the liquid cooling heat dissipation module 1. Therefore, the second vapor chamber 27 can reduce a quantity of used first heat pipes 23, costs are reduced, the heat conduction efficiency of the low-power-consumption heat generating device on the circuit board 21 is improved, impact of the fastened first heat pipe 23 on the circuit board 21 is reduced, and a yield rate of the floating module 2 is improved.

The second vapor chamber 27 may be fastened to the circuit board 21 through a fastener, or may be fastened in another manner. This is not limited herein.

In a specific embodiment, as shown in FIG. 2 to FIG. 5, there is a gap between the second vapor chamber 27 and the first vapor chamber 11.

In this embodiment, as shown in FIG. 2 to FIG. 5, there is the gap between the second vapor chamber 27 and the first vapor chamber 11, so that the floating module 2 can have space of floating relative to the liquid cooling heat dissipation module 1, to ensure that the chip 22 can be in close contact with the cooling plate 12, and ensure the heat dissipation reliability of the chip 22.

In a specific embodiment, as shown in FIG. 4, the floating module 2 further includes a second heat pipe 28, a groove 271 is disposed on a side that is of the second vapor chamber 27 and that is away from the circuit board 21, and the second heat pipe 28 is disposed in the groove 271.

In this embodiment, as shown in FIG. 4 and FIG. 5, heat absorbed by the second vapor chamber 27 in the structure can be transferred to the second heat pipe 28, to further improve temperature equalization effect of the second vapor chamber 27, thereby effectively preventing the excessively high heat of the low-power-consumption heat generating device on the circuit board 21, prolonging a service life of the circuit board 21, and improving use reliability of the electronic assembly.

As shown in FIG. 4, the second heat pipe 28 may be U-shaped, and a shape of the groove 271 matches a shape of the second heat pipe 28, to improve a laying range of the second heat pipe 28 on the second vapor chamber 27, and further improve temperature equalization effect of the second vapor chamber 27. Certainly, the second heat pipe 28 and the groove 271 may alternatively be in other shapes in cooperation with each other, for example, an L shape, and may be disposed based on a structure of the circuit board 21. This is not limited herein.

In another embodiment, based on a material of the second vapor chamber 27 and a heat dissipation requirement of the circuit board 21, the second heat pipe 28 may not be disposed on the second vapor chamber 27 shown in FIG. 4. Alternatively, as shown in FIG. 4 and FIG. 5, the second heat pipe 28 is disposed on one of second vapor chambers 27 on the two sides of the circuit board 21, and the second heat pipe 28 is not disposed on the other second vapor chamber 27. This is not limited herein.

The first vapor chamber 11 and the second vapor chamber 27 may be made of a material like titanium alloy, stainless steel, or copper as required. This is not limited herein.

In a specific embodiment, as shown in FIG. 2, FIG. 4, FIG. 5, FIG. 9, and FIG. 10, a cross section of the first heat pipe 23 is in a rectangle shape or an oblate shape, and a cross section of the second heat pipe 28 is in a rectangle shape or an oblate shape.

In this embodiment, as shown in FIG. 2, FIG. 4, FIG. 5, FIG. 9, and FIG. 10, when the cross sections of the first heat pipe 23 and the second heat pipe 28 are in the rectangle shape or the oblate shape, the first heat pipe 23 and the second heat pipe 28 can have flat surfaces, to facilitate assembly and tight pressing of the first heat pipe 23 and the second heat pipe 28, improve fastening effect of the first heat pipe 23 and the second heat pipe 28, and further reduce thicknesses of the first heat pipe 23 and the second heat pipe 28, thereby reducing an overall thickness of the electronic assembly and improving the system integration of the electronic device.

The cross sections of the first heat pipe 23 and the second heat pipe 28 may be the same or may be different. In addition, the first heat pipe 23 and the second heat pipe 28 may be in other shapes. This is not limited herein.

Embodiments of this application further provides an electronic device. As shown in FIG. 2, the electronic device includes a housing and the electronic assembly according to any one of the foregoing embodiments, and the electronic assembly is mounted in the housing. Because the electronic assembly has the foregoing technical effect, the electronic device including the electronic assembly should have corresponding technical effect. Details are not described herein again.

It should be noted that a part of this patent application document includes content protected by copyright. Except for making copies of patent documents of the China National Intellectual Property Administration or recorded content of patent documents, the copyright owner reserves the copyright.

## Claims

1. An electronic assembly, comprising:
a liquid cooling heat dissipation module (1);
a plurality of floating modules (2), wherein the plurality of floating modules (2) are spaced apart on the liquid cooling heat dissipation module (1); and
the floating module (2) comprises a circuit board (21), a chip (22), and an elastic connecting member (24), wherein the chip (22) is disposed on one side of the circuit board (21), and the circuit board (21) is connected to the liquid cooling heat dissipation module (1) through the elastic connecting member (24), wherein
the elastic connecting member (24) is configured to tightly press the circuit board (21) against the liquid cooling heat dissipation module (1), so that the chip (22) abuts against the liquid cooling heat dissipation module (1).

2. The electronic assembly according to claim 1, wherein the plurality of floating modules (2) are mounted on two opposite sides of the liquid cooling heat dissipation module (1).

3. The electronic assembly according to claim 1, wherein the elastic connecting member (24) comprises a connecting member (241) and an elastic member (242), the connecting member (241) passes through the elastic member (242), the circuit board (21) is provided with a mounting hole, and the connecting member (241) passes through the mounting hole and is connected to the liquid cooling heat dissipation module (1); and
one surface of the elastic member (242) abuts against the connecting member (241), and the other surface abuts against the circuit board (21), to tightly press the chip (22) on the circuit board (21) against the liquid cooling heat dissipation module (1).

4. The electronic assembly according to claim 3, wherein the elastic member (242) is a spring or a spring plate.

5. The electronic assembly according to claim 3, wherein the floating module (2) further comprises a first reinforcing framework (29a) and a second reinforcing framework (29b), the first reinforcing framework (29a) is connected to one side of the circuit board (21) and encloses the chip (22), and the second reinforcing framework (29b) is correspondingly disposed on the other side of the circuit board (21); and
the first reinforcing framework (29a) and the second reinforcing framework (29b) are provided with a through hole corresponding to a position of the mounting hole, and the connecting member (241) sequentially passes through the elastic member (242), the second reinforcing framework (29b), the circuit board (21), and the first reinforcing framework (29a), and is connected to the liquid cooling heat dissipation module (1).

6. The electronic assembly according to claim 1, wherein the floating module (2) further comprises a first heat pipe (23), and the first heat pipe (23) is disposed on two opposite sides of the circuit board (21); and
at least a part of the first heat pipe (23) protrudes from an edge of the circuit board (21) and is connected to the liquid cooling heat dissipation module (1).

7. The electronic assembly according to claim 6, wherein the first heat pipe (23) comprises a first section (231), a bending section (232), and a second section (233) that are sequentially connected, the first section (231) is connected to the circuit board (21), and the second section (233) is connected to the liquid cooling heat dissipation module (1).

8. The electronic assembly according to claim 7, wherein the floating module (2) further comprises a fastening sheet (25), and the fastening sheet (25) comprises a body (251) and a connecting sheet (252);
the connecting sheet (252) is connected to the liquid cooling heat dissipation module (1); and
at least a part of the second section (233) is disposed between the body (251) and the liquid cooling heat dissipation module (1).

9. The electronic assembly according to claim 8, wherein the connecting sheet (252) is provided with a fastening hole (252a), and the connecting sheet (252) is connected to the liquid cooling heat dissipation module (1) in cooperation with the fastening hole (252a).

10. The electronic assembly according to claim 9, wherein the fastening hole (252a) is a large circular hole or a groove hole.

11. The electronic assembly according to claim 8, wherein the body (251) is provided with a recessed portion (251a), and at least a part of the second section (233) is disposed in the recessed portion (251a).

12. The electronic assembly according to claim 7, wherein the floating module (2) further comprises an elastic pressing sheet (26), and two ends of the elastic pressing sheet (26) are connected to the liquid cooling heat dissipation module (1); and
at least a part of the second section (233) is disposed between the elastic pressing sheet (26) and the liquid cooling heat dissipation module (1).

13. The electronic assembly according to any one of claims 7 to 12, wherein the liquid cooling heat dissipation module (1) comprises a first vapor chamber (11) and a plurality of cooling plates (12), the plurality of cooling plates (12) are spaced apart on the first vapor chamber (11), and the plurality of cooling plates (12) protrude from the first vapor chamber (11);
positions of the plurality of cooling plates (12) correspond to positions of the plurality of floating modules (2); and
the chip (22) abuts against the cooling plate (12), and the second section (233) is connected to the first vapor chamber (11).

14. The electronic assembly according to claim 13, wherein the floating module (2) further comprises a second vapor chamber (27), and the second vapor chamber (27) is fastened on two opposite sides of the circuit board (21); and
at least a part of the first section (231) is disposed between the second vapor chamber (27) and the circuit board (21).

15. The electronic assembly according to claim 14, wherein there is a gap between the second vapor chamber (27) and the first vapor chamber (11).

16. The electronic assembly according to claim 14, wherein the floating module (2) further comprises a second heat pipe (28), a groove (271) is disposed on a side that is of the second vapor chamber (27) and that is away from the circuit board (21), and the second heat pipe (28) is disposed in the groove (271).

17. The electronic assembly according to claim 16, wherein a cross section of the first heat pipe (23) is in a rectangle shape or an oblate shape; and
a cross section of the second heat pipe (28) is in a rectangle shape or an oblate shape.

18. An electronic device, wherein the electronic device comprises a housing and the electronic assembly according to any one of claims 1 to 17, and the electronic assembly is mounted in the housing.
